# EUROPEAN PATENT APPLICATION

(11) **EP 1 313 146 A2**
(43) Date of publication of application: **21.05.2003**
(21) Application number: 02257775.3
(22) Date of filing: 08.11.2002
(51) Int. Cl.: H01L 27/06

(54) **Monolithically integrated pin diode and schottky diode circuit and method of fabricating same**

(30) Priority: 08.11.2001 US 5513
(71) Applicant: Tyco Electronics Corporation, Middletown, Pennsylvania 17057 (US)
(72) Inventor: Brogle, James Joseph, Woburn, MA 01801 (US); Goodrich, Joel Lee, Westford, MA 01886 (US); Curcio, Daniel Gustavo, Nashua, NH 03062 (US)
(74) Representative: Warren, Keith Stanley

(57) **Abstract**

A Microwave/Millimeter-wave Monolithic Integrated Circuit (MMIC) device (100) including PIN diode and Schottky diode circuits (102, 104) provides improved performance with a reduced cost of manufacture. The planar, glass-passivated, MMIC device is fabricated in silicon technology and includes mesa isolation (110,112) between the PIN diode (102) and the Schottky diode (104). The PIN and Schottky diodes include respective anode regions (122,116) having different thicknesses and resistivity for implementing the PIN and Schottky diode functions. Furthermore, the Schottky anode region (116) is formed relatively late in the process for fabricating the Si MMIC device to allow the Schottky anode region (116) to be formed in approximately the same plane as the PIN anode region (122) and to allow precise control of the relative thicknesses of the PIN and Schottky anode regions.

## Description

### BACKGROUND OF THE INVENTION

The present invention relates generally to microwave/millimeter-wave monolithic integrated circuits, and, more specifically, to a microwave/millimeter-wave monolithic integrated circuit including PIN and Schottky diodes that provides improved performance with a reduced cost of manufacture.

In recent years, there has been an increasing need for improved methods of fabricating monolithically integrated PIN and Schottky diode circuits for use in implementing functions, such as, switch/mixer functions, limiter/attenuator functions and limiter/amplifier functions in radar systems, wireless communications systems and other microwave/millimeter-wave systems and devices. In general, fabricating PIN and Schottky diodes on the same microwave/millimeter-wave monolithic integrated circuit ("chip") can reduce device size, increase system reliability and reduce costs.

A conventional method of fabricating monolithically integrated PIN diode and Schottky diode circuits is described in US-A-5,753,960 (the '960 patent). The method of the '960 patent involves monolithically integrating PIN and Schottky diode circuits on the same chip using Gallium Arsenide (GaAs) technology. Specifically, the PIN and Schottky diodes are fabricated from a common semiconductor layer sequence comprising highly doped p-contact and n-contact layers and a lightly doped insulating layer grown between the p-contact and n-contact layers. The insulating layer includes an etch-arresting layer disposed a defined distance from one of the contact layers. The chip fabrication method includes (1) growing the n-contact (epitaxial) layer, the insulating layer including the etch-arresting layer, and the p-contact layer on a semiconductor substrate, (2) removing the p-contact layer and the insulating layer in the Schottky diode region with an etching agent so that the etching agent is stopped at the etch-arresting layer, which is thereby exposed, (3) removing the exposed etch-arresting layer in the Schottky diode region, (4) etching away the insulating layer in a cathode area of the PIN diode region, and (5) patterning electrical contacts on both the PIN and Schottky diode regions. By using the etch-arresting layer to stop the etching agent after having removed the p-contact layer and an upper portion of the insulating layer in the Schottky diode region, a relatively thin insulating layer remains in an anode region of the Schottky diode for use in implementing the Schottky diode function, while a thicker insulating layer is provided in an anode region of the PIN diode for use in implementing the PIN diode function.

Although the monolithically integrated PIN and Schottky diode circuits described in the '960 patent can be employed to carry out certain required functions in microwave/millimeter-wave systems and devices, the PIN and Schottky diodes of the '960 patent have drawbacks. For example, the PIN and Schottky diodes are disposed across three (3) different semiconductor layers, in which each layer constitutes a different level in the disclosed semiconductor layer sequence. Specifically, the cathode of the PIN diode is disposed on the n-epitaxial layer, the anode of the PIN diode is disposed on the p-contact layer and the electrical contacts of the Schottky diode are disposed on the relatively thin insulating layer between the n-epitaxial layer and the p-contact layer. Having portions of the PIN and Schottky diodes disposed across different levels of the semiconductor layer sequence can increase the complexity of PIN and Schottky diode circuit layouts and, also, make it more difficult to affect electrical isolation between the respective PIN and Schottky diode regions. Moreover, GaAs-based semiconductor material is inherently costly and usually only used at very high frequencies.

It would therefore be desirable to have a microwave/millimeter-wave monolithic integrated circuit including PIN and Schottky diodes that can be used to implement required functions in radar systems, wireless communications systems and other microwave/millimeter-wave systems and devices. Such a chip would be fabricated in a manner that simplifies PIN and Schottky diode circuit layouts and facilitates electrical isolation between the respective PIN and Schottky diode regions. It would also be desirable to have a microwave/millimeter-wave monolithic integrated circuit with PIN and Schottky diodes that can be fabricated in a low cost semiconductor technology.

### BRIEF SUMMARY OF THE INVENTION

In accordance with the present invention, a Microwave/Millimeter-wave Monolithic Integrated Circuit (MMIC) device including PIN diode and Schottky diode circuits is disclosed that provides improved performance with a reduced cost of manufacture. Benefits of the presently disclosed invention are achieved by fabricating the MMIC device in a low-cost Silicon (Si) technology using a planar process that simplifies PIN and Schottky diode circuit layouts and facilitates the formation of separate mesas for electrically isolating the PIN and Schottky diode regions.

In one embodiment, the MMIC device comprises a planar, glass-passivated, Si MMIC device with mesa isolation between at least one PIN diode and at least one Schottky diode. The PIN diode and the Schottky diode include respective anode regions having different thicknesses and resistivity for implementing the PIN and Schottky diode functions. Further, the anode region of the Schottky diode is formed relatively late in the process for fabricating the Si MMIC device, *i.e*., after forming the respective mesas and applying/planarizing the glass passivation layer, to allow the Schottky anode region to be formed in approximately the same plane as the PIN anode region and to allow precise control of the thickness of the Schottky anode region.

The process for fabricating the Si MMIC device including the PIN diode and Schottky diode circuits comprises (1) providing a silicon substrate of a first conductivity type, preferably an n-type Si substrate, (2) growing a first intrinsic epitaxial layer of a first conductivity type, preferably the n-type conductivity, adjacent the n-substrate, (3) growing a first layer of thermal Silicon Dioxide (SiO₂) adjacent the first n-epitaxial layer, (4) applying a first mask to define an anode region of the PIN diode, conducting an anode etch and a Boron implant to form the ion-implanted (p+) PIN anode region, growing a second layer of thermal SiO₂ adjacent the PIN anode region, and removing the first mask, and (5) depositing a first layer of Silicon Nitride (Si₃N₄) adjacent the first and second SiO₂ layers and a first layer of Low Temperature Oxide (LTO) adjacent the first Si₃N₄ layer by a Chemical Vapor Deposition (CVD) process.

The Si MMIC device fabrication process further comprises (6) applying a second mask to protect the anode region of the PIN diode, removing the LTO layer, the first Si₃N₄ layer, and the first thermal SiO₂ layer except in the protected PIN anode region, and removing the second mask, (7) depositing a second Si₃N₄ layer by CVD, (8) applying a third mask to protect portions of the second Si₃N₄ layer adjacent areas that are to become respective mesa regions of the PIN and Schottky diodes, conducting an etch of the second Si₃N₄ layer except in the protected portions of the second Si₃N₄ layer, and removing the third mask, and (9) conducting an anisotropic etch to form the respective mesa regions of the PIN and Schottky diodes.

Still further, the Si MMIC device fabrication process comprises (10) removing the second Si₃N₄ layer to leave the entire Schottky mesa region open and at least a portion of the PIN mesa region open except in the area adjacent the PIN anode, and (11) conducting a phosphorous implant to form an ion-implanted (n+) layer adjacent each mesa region except in the area of the PIN anode for electrically shorting the open areas of each mesa to the n-substrate and for providing suitable locations for subsequent electrical contact formation.

Yet further, the Si MMIC device fabrication process comprises (12) depositing a third layer of Si₃N₄ and a second layer of LTO by CVD, (13) depositing and planarizing the low-loss glass passivation layer adjacent the second LTO layer to achieve a predetermined thickness of the glass above the respective mesa plateaus, (14) applying a fourth mask to define locations of the electrical contacts, conducting an etch through the glass passivation layer at the defined electrical contact locations, and removing the fourth mask, (15) growing a second epitaxial layer of a first conductivity type, preferably the n-type conductivity, in the electrical contact location adjacent the Schottky mesa by an Ultra-High Vacuum Chemical Vapor Deposition (UHVCVD) process, thereby forming the Schottky anode region with a precisely controlled thickness, and (16) applying a fifth mask to protect the Si MMIC device except at the electrical contact locations, depositing layers of metal at the defined electrical contact locations to provide a Schottky barrier adjacent the second n-epitaxial layer and respective ohmic contacts at the remaining electrical contact locations, and removing the fifth mask.

By employing a planar Si process to fabricate the presently disclosed MMIC device, PIN diode and Schottky diode circuit layouts are simplified and mesa isolation between the respective PIN and Schottky diode regions is made easier. Further, by fabricating the MMIC device including the PIN and Schottky diode circuits in Si technology, manufacturing costs are reduced.

### BRIEF DESCRIPTION OF THE ACCOMPANYING DRAWINGS

Fig. 1 depicts a cross-sectional view of a microwave/millimeter-wave monolithic integrated circuit device including a series PIN diode and a series Schottky diode according to the present invention;
Figs. 2a-5b depict cross-sectional views of respective layer sequences and layer arrangements of the series PIN diode and the series Schottky diode of Fig. 1 fabricated in silicon technology according to the present invention;
Fig. 6 depicts a cross-sectional view of the microwave/millimeter-wave monolithic integrated circuit device of Fig. 1 before a back surface of the device is ground off for electrically isolating the PIN and Schottky diode sections; and
Fig. 7 depicts a cross-sectional view of a microwave/millimeter-wave monolithic integrated circuit device including a shunt PIN diode and a shunt Schottky diode according to the present invention.

### DETAILED DESCRIPTION OF THE EMBODIMENTS

A Microwave/Millimeter-wave Monolithic Integrated Circuit (MMIC) device including PIN diode and Schottky diode circuits is provided having improved performance and a reduced cost of manufacture. The presently disclosed MMIC device is fabricated in a low-cost Silicon (Si) technology using a planar process that simplifies PIN and Schottky diode circuit layouts and facilitates mesa isolation of the PIN and Schottky diode regions.

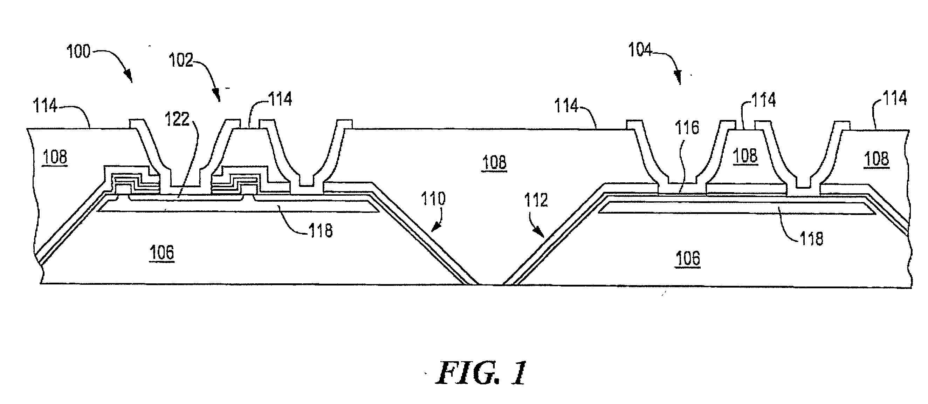

Fig. 1 depicts a cross-sectional view of a Si MMIC device 100 in accordance with the present invention. In the illustrated embodiment, the Si MMIC device 100 includes at least one series PIN diode 102 and at least one series Schottky diode 104 monolithically integrated on a Si substrate 106 of the device 100. A front surface of the Si MMIC device 100 comprising surfaces 114 of a glass passivation layer 108 is configured to be substantially planar to simplify subsequent layering and/or patterning operations. For example, the planar surface of the Si MMIC device 100 makes patterning subsequent metal interconnections, transmission lines and passive elements much easier. Further, mesas 110 and 112 are etched around the PIN diode 102 and the Schottky diode 104, respectively, to provide electrical isolation between the PIN and Schottky diode regions. Moreover, an anode region 116 of the Schottky diode 104 is grown after the mesas 110 and 112 are etched and the glass passivation layer 108 is deposited to allow the Schottky anode region 116 to be formed in approximately the same plane as an anode region 122 of the PIN diode 102 and to allow precise control of the relative thicknesses of the Schottky and PIN anode regions 116 and 122.

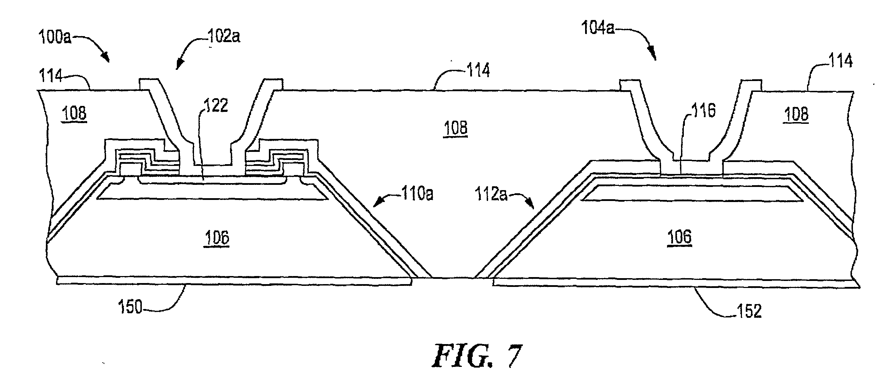

It should be understood that the presently disclosed device fabrication techniques may be used to fabricate a Si MMIC device that includes at least one shunt PIN diode and at least one shunt Schottky diode. Fig. 7 depicts a cross-sectional view of a Si MMIC device 100a including a shunt PIN diode 102a and a shunt Schottky diode 104a monolithically integrated on a Si substrate 106 of the device 100a. It is noted that in Figs. 1 and 7, like reference numbers indicate identical or functionally similar elements. Specifically, mesas 110a and 112a are etched around the shunt PIN diode 102a and the shunt Schottky diode 104a, respectively, for electrically isolating the PIN and Schottky diode regions. Further, an anode region 116 of the shunt Schottky diode 104a is formed in approximately the same plane as an anode region 122 of the shunt PIN diode 102a. Moreover, patterned metal layers or ground planes 150 and 152 are deposited on a back surface of the Si MMIC device 100a to provide cathode contacts for the shunt PIN and Schottky diodes 102a and 104a, respectively. The presently disclosed device fabrication techniques are described herein with reference to the Si MMIC device 100 (see Fig. 1) including the series PIN and Schottky diodes 102 and 104 for clarity of discussion.

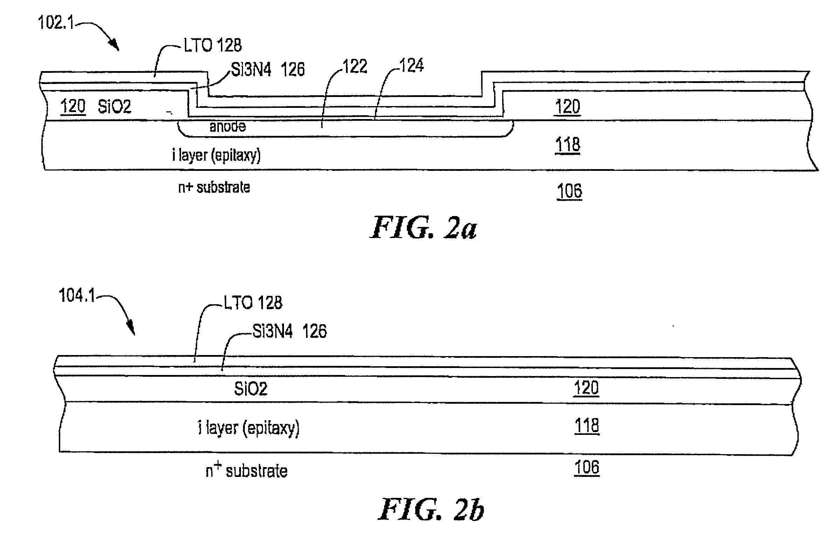

Figs. 2a-5b depict cross-sectional views of respective layer sequences and layer arrangements of the PIN diode 102 (see Fig. 1) and the Schottky diode 104 (see Fig. 1) fabricated in silicon technology, in accordance with the present invention. It is noted that Figs. 2a, 3a, 4a, and 5a depict the layer sequences/arrangements of the PIN diode 102 at respective steps of the device fabrication process, and Figs. 2b, 3b, 4b, and 5b depict the layer sequences/arrangements of the Schottky diode 104 at the same respective fabrication process steps. It should also be understood that the cross-sections of the PIN diode shown in Figs. 2a, 3a, 4a, and 5a, and the cross-sections of the Schottky diode shown in Figs. 2b, 3b, 4b, and 5b are representative of different regions of the same Si wafer.

Fig. 2a depicts a layer sequence/arrangement 102.1 corresponding to the PIN diode region and Fig. 2b depicts a layer sequence/arrangement 104.1 corresponding to the Schottky diode region of the Si wafer. In the illustrated embodiment, the layer sequences/arrangements 102.1 and 104.1 represent respective configurations of the PIN and Schottky diode regions after completing the first five (5) steps of the process for fabricating the Si MMIC device 100 (see Fig. 1).

The first step of the device fabrication process includes providing the Si substrate 106 (see Figs. 2a and 2b), which is preferably an n-type Si substrate. The second step of the fabrication process comprises a layering operation that includes growing a first intrinsic n-type epitaxial layer 118 (see Figs. 2a and 2b) adjacent the n-substrate 106 by, *e.g.,* a suitable Chemical Vapor Deposition (CVD) process. For example, the n-epitaxial layer 118 may be grown to provide a layer thickness of about 1 µm to about 75 µm. The third step of the fabrication process also comprises a layering operation, which includes growing a first layer 120 (see Figs. 2a and 2b) of thermal Silicon Dioxide (SiO₂) adjacent the n-epitaxial layer 118. For example, the first SiO₂ layer 120 may be grown to provide a layer thickness of about 5,000 Å.

The fourth step of the device fabrication process comprises patterning, doping and layering operations. The patterning operation includes applying a first mask to define an anode region 122 of the PIN diode at a predetermined location on the Si wafer, and etching a window corresponding to the defined anode region 122 to form an opening in the SiO₂ layer 120. The doping operation is then performed to implant a dopant, *e.g.,* Boron (p+), in the anode region 122 through the opening in the SiO₂ layer 120 so that the resulting p-anode region 122 and the n-epitaxial layer 118 form a PN junction of the PIN diode. Next, the layering operation is performed to grow a second layer 124 (see Fig. 2a) of thermal SiO₂ having a layer thickness of about 180 Å adjacent the anode 122 of the PIN diode. The first mask is then removed.

The fifth step of the device fabrication process comprises respective layering operations including depositing a first layer 126 (see Figs. 2a and 2b) of Silicon Nitride (Si₃N₄) having a layer thickness of about 1,500 Å adjacent the first and second SiO₂ layers 120 and 124, and depositing a first layer 128 (see Figs. 2a and 2b) of Low Temperature Oxide (LTO) having a layer thickness of about 2,000 Å adjacent the Si₃N₄ layer 126. For example, the Si₃N₄ layer 126 and the LTO layer 128 may be deposited by a suitable CVD process.

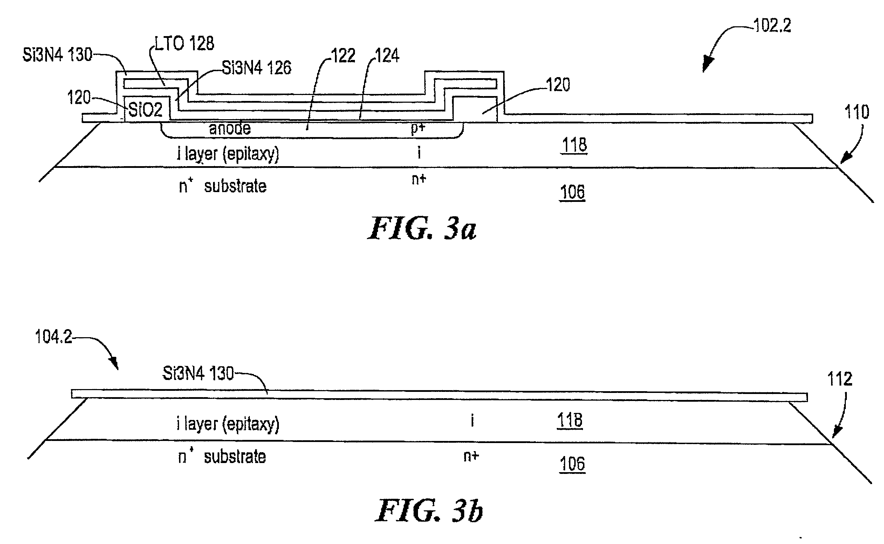

Fig. 3a depicts a layer sequence/arrangement 102.2 corresponding to the PIN diode region, and Fig. 3b depicts a layer sequence/arrangement 104.2 corresponding to the Schottky diode region of the Si wafer. In the illustrated embodiment, the layer sequences/arrangements 102.2 and 104.2 represent respective configurations of the PIN and Schottky diode regions after completing the sixth through ninth steps of the process for fabricating the Si MMIC device 100 (see Fig. 1).

The sixth step of the device fabrication process comprises a patterning operation that includes applying a second mask to protect the anode region 122 of the PIN diode, removing the LTO layer 128, the Si₃N₄ layer 126 and the SiO₂ layer 120, except in the area adjacent protected PIN anode region 122, and removing the second mask. The seventh step of the fabrication process comprises a layering operation that includes depositing a second Si₃N₄ layer 130 (see Figs. 3a and 3b) having a layer thickness of about 1,500 Å adjacent the LTO layer 128 in the PIN diode region and adjacent the n-epitaxial layer 118 in the Schottky diode region by, *e.g*., a suitable CVD process.

The eighth step of the device fabrication process comprises a patterning operation that includes applying a third mask to protect portions of the Si₃N₄ layer 130 near areas that are to become the mesa 110 (see Fig. 3a) and the mesa 112 (see Fig. 3b) of the PIN diode and the Schottky diode, respectively, conducting an etch of the Si₃N₄ layer 130, except in the portions protected by the third mask, and removing the third mask. The ninth step of the fabrication process comprises another patterning operation that includes conducting an anisotropic etch to form the respective mesa regions 110 and 112 of the PIN and Schottky diodes. In the illustrated embodiment, the portions of the Si₃N₄ layer 130 that were not etched in the eighth step are employed as a mask in the patterning operation of the ninth step. Further, as shown in Figs. 3a and 3b, the anisotropic etch is performed to etch a predetermined depth into the n-substrate 106 beyond the junction of the n-substrate 106 and the n-epitaxial layer 118.

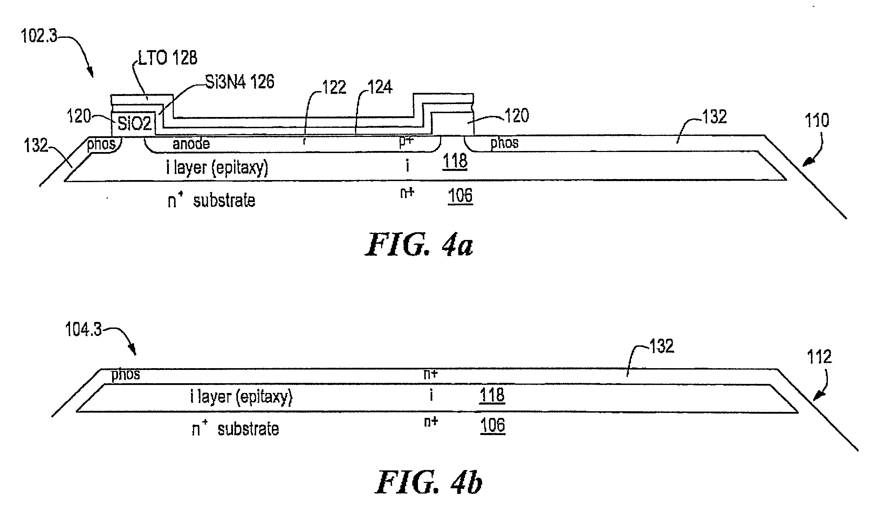

Fig. 4a depicts a layer sequence/arrangement 102.3 corresponding to the PIN diode region, and Fig. 4b depicts a layer sequence/arrangement 104.3 corresponding to the Schottky diode region of the Si wafer. In the illustrated embodiment, the layer sequences/arrangements 102.3 and 104.3 represent respective configurations of the PIN and Schottky diode regions after completing the tenth and eleventh steps of the process for fabrication the Si MMIC device 100 (see Fig. 1).

The tenth step of the device fabrication process comprises a patterning operation that includes removing the Si₃N₄ layer 130 (see Figs. 3a and 3b) to leave the entire Schottky mesa region 112 open and at least a portion of the PIN mesa region 110 open, except in the area adjacent the PIN anode 122, which includes the SiO₂ layer 120, the SiO₂ layer 124, the Si₃N₄ layer 126 and the LTO layer 128. The eleventh step of the fabrication process comprises a doping operation that includes implanting phosphorous in the surface of the n-epitaxial layer 118 corresponding to the open regions of the mesas 110 and 112 to form an ion-implanted (n+) layer 132 (see Figs. 4a and 4b). The phosphorous implantation forms the n-layer 132 on the respective plateaus of the mesas 110 and 112 (except in the area adjacent the PIN anode 122) and on sidewalls of the mesas 110 and 112, thereby electrically shorting the open area of each mesa to the n-substrate 106 and providing suitable locations on the mesa plateaus for subsequent electrical contact formation.

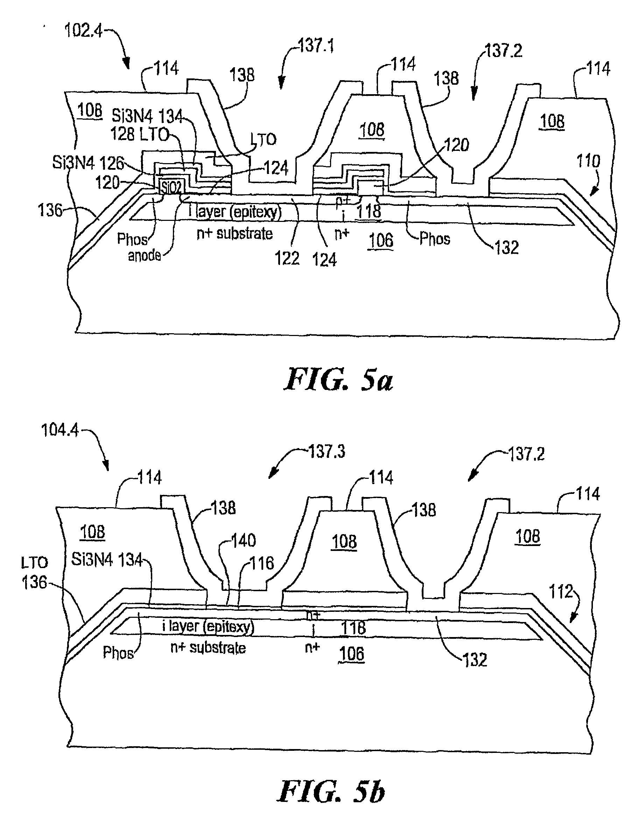

Fig. 5a depicts a layer sequence/arrangement 102.4 corresponding to the PIN diode region, and Fig. 5b depicts a layer sequence/arrangement 104.4 corresponding to the Schottky diode region of the Si wafer. In the illustrated embodiment, the layer sequences/arrangements 102.4 and 104.4 represent respective configurations of the PIN and Schottky diode regions after completing the twelfth through sixteenth steps of the process for fabricating the Si MMIC device 100 (see Fig. 1).

The twelfth step of the device fabrication process comprises a layering operation that includes depositing a third Si₃N₄ layer 134 (see Figs. 5a and 5b) having a layer thickness of about 1,500 Å adjacent the LTO layer 128 in the PIN anode region 122 (see Fig. 5a) and adjacent the phosphorous layer 132 in the remaining PIN and Schottky diode regions. The layering operation of the twelfth step also includes depositing a second LTO layer 136 having a layer thickness of about 4,000 Å adjacent the Si₃N₄ layer 134. For example, the Si₃N₄ layer 134 and the LTO layer 136 may be deposited by a suitable CVD process. The thirteenth step of the fabrication process comprises a layering operation that includes depositing and planarizing the glass passivation layer 108 having a layer thickness of about 5 µm above the respective plateaus of the mesas 110 and 112. In a preferred embodiment, the layer 108 comprises a low-loss glass passivation layer. The fourteenth step of the fabrication process comprises a patterning operation that includes applying a fourth mask to define electrical contact locations 137.1-137.4 (see Figs. 5a and 5b) on the surface 114 of the glass passivation layer 108, etching windows corresponding to the defined contact locations 137.1-137.4 to form openings in the glass passivation layer 108, and removing the fourth mask.

The fifteenth step of the device fabrication process comprises a layering operation that includes growing the second intrinsic n-type epitaxial layer 116 (see Fig. 5b) on the phosphorous layer 132 at the electrical contact location 137.3 to form the anode region of the Schottky diode. In the illustrated embodiment, the relatively thin n-epitaxial layer 116 forming the Schottky anode region is disposed in approximately the same plane as the thicker anode region 122 of the PIN diode. For example, the Schottky anode region 116 may have a layer thickness of about 0.1 µm. In a preferred embodiment, the n-epitaxial layer 116 is grown by a suitable Ultra-High Vacuum Chemical Vapor Deposition (UHVCVD) process at a predetermined temperature less than the transition temperature of the glass passivation layer 108. Such a UHVCVD pocess is described in US-A-5,298,452. It is understood, however, that the n-epitaxial layer 116 may alternatively be formed by way of any process capable of forming a thin, high quality, epitaxial layer at temperatures less than the transition temperature of the glass passivation layer.

The sixteenth step of the device fabrication process comprises a layering operation that includes applying a fifth mask to protect the front surface of the Si MMIC device 100 except at the electrical contact locations 137.1-137.4, depositing a layer 138 (see Figs. 5a and 5b) of metal at the electrical contact locations 137.1-137.4 to provide a Schottky barrier 140 (see Fig. 5b) between the n-epitaxial layer 116 and the metal layer 138 at the contact location 137.3 (the Schottky anode) and respective ohmic contacts at the contact location 137.4 (the Schottky cathode), the contact location 137.1 (the PIN anode) and the contact location 137.2 (the PIN cathode). It is noted that the metal layer 138 usually comprises a sequence of layers that may include platinum (Pt), titanium (Ti), nickel (Ni), silver (Ag), gold (Au), aluminum (A1) and/or any other suitable metal layer. The first layer for the Schottky device is typically chosen to create the correct Schottky barrier height.

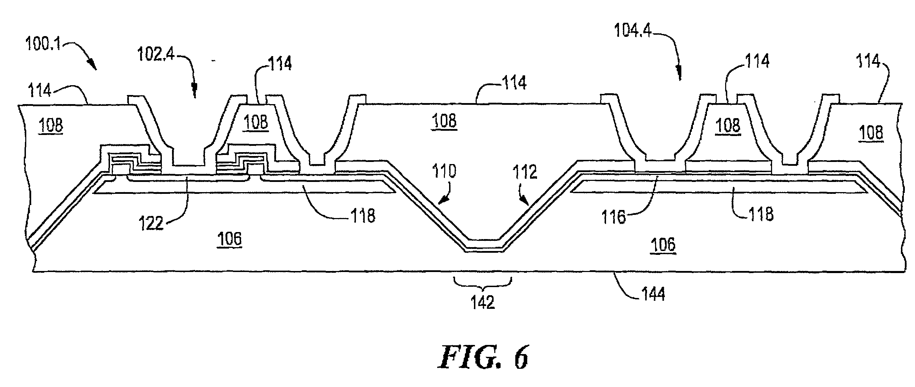

Fig. 6 depicts a cross-sectional view 100.1 of the Si MMIC device before performing the seventeenth step of the device fabrication process. As shown in Fig. 6, the layer sequence/arrangement 102.4 (see also Fig. 5a) corresponding to the PIN diode region, and the layer sequence/arrangement 104.4 (see also Fig. 5b) corresponding to the Schottky diode region, are disposed in different regions of the same Si wafer.

As described above, the ninth step of the device fabrication process includes anisotropically etching the n-substrate 106 a predetermined depth that extends beyond the n-epitaxial layer 118 to form the mesas 110 and 112. After the n-substrate 106 is anisotropically etched in the ninth step, a portion 142 (see Fig. 6) of the n-substrate 106 typically remains to form a short circuit between the respective mesa regions 110 and 112 of the PIN and Schottky diodes.

In the illustrated embodiment, the seventeenth step of the device fabrication process includes grinding a back surface 144 of the Si wafer to remove the short circuit formed by the n-substrate portion 142, thereby electrically isolating the PIN diode and Schottky diode sections. It is noted that Fig. 1 depicts the Si MMIC device 100 including the PIN diode 102 and Schottky diode 104 after completing the seventeenth step, *i.e*., after the back surface 144 of the Si wafer is ground off to achieve electrical isolation between the PIN diode 102 and the Schottky diode 104.

After the Si MMIC device 100 including the PIN diode 102 and the Schottky diode 104 is fabricated by way of the above-described device fabrication process, interconnections between the PIN diode 102, the Schottky diode 104 and other passive and/or active circuits disposed on the same Si wafer can be made by, *e.g.,* forming airbridges and/or microstrip transmission lines on the planar surface 114 of the glass passivation layer 108. For the series PIN diode 102 and the series Schottky diode 104 (see Fig. 1), the back surface of the Si mesas can be etched to a predetermined depth and then filled with an insulating material and planarized. For the shunt PIN diode 102a and the shunt Schottky diode 104a (see Fig. 7), the ground plane metalization can be deposited on the back surface of the wafer to complete the device fabrication process.

By maintaining a planar process throughout the fabrication of the Si MMIC device 100, interconnections between PIN and Schottky diode circuits and other circuit elements formed on the planar MMIC device are simplified. Further, respective mesas configured to provide electrical isolation between the PIN and Schottky diode regions can be formed by a single anisotropic etch. Moreover, because the Schottky anode region is formed relatively late in the device fabrication process, relatively thick and thin PIN and Schottky anode regions can be selectively formed in approximately the same plane for implementing the PIN and Schottky diode functions, respectively.

## Claims

1. A microwave/millimeter-wave monolithic integrated circuit device (100,100a), comprising:
a semiconductor substrate (106);
at least one first mesa portion (100,110a) and at least one second mesa portion (112,112a) formed on the substrate;
at least one PIN diode (102,102a) formed on the first mesa portion (110,110a) and including a PIN anode region (122);
at least one Schottky diode (104,104a) formed on the second mesa portion (112,112a) and including a Schottky anode region (116); and
a passivation layer (108) deposited on the substrate to cover the PIN diode, the Schottky diode, the first mesa portion and the second mesa portion while providing access to at least the PIN anode region (122) and the Schottky anode region (116),
the PIN anode region (122) being formed in approximately the same plane as the Schottky anode region (116).

2. The circuit device of claim 1 wherein the semiconductor substrate comprises a silicon substrate (106).

3. The circuit device of claim 1 or 2 wherein the passivation layer comprises a low-loss glass passivation layer (108).

4. The circuit device of claim 1, 2 or 3 wherein the Schottky anode region (116) is formed subsequent to the deposition of the passivation layer (108).

5. The circuit device of claim 1, 2, 3 or 4 wherein the Schottky anode region includes a thin epitaxial layer (116)formed by an ultra-high vacuum chemical vapor deposition process.

6. The circuit device of claim 5 wherein the thin epitaxial layer of the Schottky anode region has a thickness equal to about 0.1 µm.

7. The circuit device of any preceding claim wherein the first (110,110a) and second (112,112a) mesa portions are formed on the substrate (106) by way of a single anisotropic etching operation.

8. A method of fabricating a microwave/millimeter-wave monolithic integrated circuit device (100, 100a) including at least one PIN diode (102,102a) and at least one Schottky diode (104,104a), comprising the steps of:
providing a semiconductor substrate (106);
forming at least one first mesa portion (110, 110a) and at least one second mesa portion (112,112a) on the substrate;
forming the PIN diode including a PIN anode (122) in a PIN diode region of the substrate, the PIN diode being formed on the first mesa portion (110, 110a);
forming the Schottky diode including a Schottky anode (116) in a Schottky diode region of the substrate, the Schottky diode being formed on the second mesa portion (112, 112a), and the Schottky anode being formed in approximately the same plane as the PIN anode; and
depositing a passivation layer (108) on the substrate (106) to cover the PIN diode, the Schottky diode, the first mesa portion and the second mesa portion while providing access to at least the PIN (122) anode and the Schottky anode (116).

9. The method of claim 8 wherein the semiconductor substrate comprises a silicon substrate (106).

10. The method of claim 8 or 9 wherein the passivation layer comprises a low-loss glass passivation layer (108).

11. The method of claim 8, 9 or 10 wherein the first forming step includes forming the first mesa portion (110,110a) and the second mesa portion (112,112a) on the substrate (106) by way of a single anisotropic etching operation.

12. The method of claim 11 wherein the first forming step includes depositing a layer of silicon nitride on the PIN diode region and the Schottky diode region of the substrate (106), masking portions of the PIN diode region and the Schottky diode region that are to become the first and second mesa portions, etching the silicon nitride layer except in the masked portions of the PIN diode and Schottky diode regions, and conducting the single anisotropic etching operation to form the first and second mesa portions on the substrate.

13. The method of any preceding claim 8 to 12 wherein the second forming step includes etching an implant window for the PIN anode in the PIN diode region of the substrate (106) while masking the Schottky diode region of the substrate, and implanting a dopant through the implant window for the PIN anode (122) in the PIN diode region of the substrate while masking the Schottky diode region of the substrate.

14. The method of any preceding claim 8 to 13 wherein the third forming step includes forming the Schottky anode (116) subsequent to the deposition of the passivation layer (108).

15. The method of claim 14 wherein the third forming step includes forming a thin epitaxial layer of the Schottky anode (116) in the Schottky diode region of the substrate (106) by an ultra-high vacuum chemical vapor deposition process while masking the PIN diode region of the substrate.

16. The method of claim 15 wherein the thin epitaxial layer of the Schottky anode (116) is found at a predetermined temperature less than a transition temperature of the passivation layer (108).
